# EUROPEAN PATENT APPLICATION

(11) **EP 3 582 341 A1**
(43) Date of publication of application: **18.12.2019**
(21) Application number: 19173410.2
(22) Date of filing: 09.05.2019
(51) Int. Cl.: H01R 24/42, H01R 9/05, H01L 21/56, H01R 4/18, H01R 13/11, H01R 13/66

(54) **INNER CONDUCTOR TERMINAL AND COAXIAL CABLE TERMINAL UNIT USING INNER CONDUCTOR TERMINAL**

(30) Priority: 13.06.2018 JP 2018113124
(71) Applicant: Yazaki Corporation, Minato-ku Tokyo 108-8333 (JP)
(72) Inventor: KAMEYAMA, Isao, Makinohara-shi, Shizuoka 421-0407 (JP); SAITO, Atsuhito, Makinohara-shi, Shizuoka 421-0407 (JP); WADA, Yoshimi, Makinohara-shi, Shizuoka 421-0407 (JP)
(74) Representative: Grünecker Patent- und Rechtsanwälte PartG mbB

(57) **Abstract**

An inner conductor terminal includes a connection terminal, a crimping terminal, a chip-type electronic element, and a molded portion. The connection terminal includes a connection portion that is connected to a mating terminal at a tip end portion thereof. The crimping terminal includes an inner conductor crimping portion that crimps an inner conductor of a coaxial cable at a base end portion thereof. The chip-type electronic element is mounted on a base end portion of the connection terminal and a tip end portion of the crimping terminal so as to couple the base end portion of the connection terminal with the tip end portion of the crimping terminal. The molded portion covers peripheries of the base end portion of the connection terminal, the tip end portion of the crimping terminal, and the chip-type electronic element.

## Description

### BACKGROUND OF THE INVENTION

### <Field of the Invention>

The present invention relates to an inner conductor terminal and a coaxial cable terminal unit using the inner conductor terminal.

### <Description of Related Art>

A coaxial cable terminal unit is widely known in the related art, which includes an inner conductor terminal that is connected to a mating terminal and is conductively connected to an inner conductor of a coaxial cable, a dielectric that accommodates and retains the inner conductor terminal, and an outer conductor terminal that is internally provided with the dielectric and is conductively connected to an outer conductor of the coaxial cable.

When such a coaxial cable terminal unit is used as, for example, a terminal of an antenna wire (coaxial cable) for an in-vehicle radio, a technique of mounting a chip-type electronic element on an inner conductor terminal is known (see, for example, Patent Document 1: JP-A-2004-71208) . For example, a chip capacitor for adjusting electrostatic capacity and improving noise resistance is mounted as the electronic element.

Specifically, the inner conductor terminal described in the above document is separately provided with a connection terminal at a tip end portion that is connected to a mating terminal, and a crimping terminal at a base end portion that crimps the inner conductor of the coaxial cable. The chip-type electronic element is mounted on a base end portion of the connection terminal and a tip end portion of the crimping terminal by soldering, so as to couple the base end portion of the connection terminal with the tip end portion of the crimping terminal in a separated state. In order to protect the chip-type electronic element, peripheries of the base end portion of the connection terminal, the tip end portion of the crimping terminal, and the chip-type electronic element are covered with a molded portion formed of resin.

### [Patent Document 1] JP-A-2004-71208

In the inner conductor terminal described in the above document, the adhesion force in adhesion portions is relatively small. The adhesion portions are respectively located between the molded portion formed of resin and the base end portion of the connection terminal formed of metal, and between the molded portion formed of resin and the tip end portion of the crimping terminal formed of metal. Therefore, when an external force is applied to either or both of the connection terminal and the crimping terminal constituting the inner conductor terminal during insertion of the mating terminal or routing to the vehicle, the external force is likely to transmit to solder that connects and fixes the base end portion of the connection terminal and the tip end portion of the crimping terminal to the chip-type electronic element. As a result, an excessive stress acts on the solder, which may reduce reliability of electrical connection via soldering.

### SUMMARY

One or more embodiments provide an inner conductor terminal, which can maintain good electrical connection reliability and is provided with a chip-type electronic element, and a coaxial cable terminal unit using the inner conductor terminal.

In an aspect (1), one or more embodiments provide an inner conductor terminal including a connection terminal, a crimping terminal, a chip-type electronic element, and a molded portion. The connection terminal includes a connection portion that is connected to a mating terminal at a tip end portion thereof. The crimping terminal includes an inner conductor crimping portion that crimps an inner conductor of a coaxial cable at a base end portion thereof. The chip-type electronic element is mounted on a base end portion of the connection terminal and a tip end portion of the crimping terminal so as to couple the base end portion of the connection terminal with the tip end portion of the crimping terminal. The molded portion covers peripheries of the base end portion of the connection terminal, the tip end portion of the crimping terminal, and the chip-type electronic element. At least one of the base end portion of the connection terminal and the tip end portion of the crimping terminal includes a convex portion or a recessed portion on a surface thereof. The molded portion covers a periphery of the convex portion or enters the recessed portion.

In an aspect (2), each of the base end portion of the connection terminal and the tip end portion of the crimping terminal has a flat-plate shape. The recessed portion includes a through hole penetrating in a plate thickness direction. The inside of the through hole is filled with the molded portion.

In an aspect (3), the through hole includes a protruding portion extending from an inner wall surface of the through hole toward a radially inner side.

In an aspect (4), a coaxial cable terminal unit includes the inner conductor terminal according to any one of the aspects (1) to (3), a dielectric, and an outer conductor terminal. A terminal accommodation chamber accommodating and retaining the inner conductor terminal is formed through the dielectric. The outer conductor terminal includes a shell portion internally provided with the dielectric at a tip end portion thereof and an outer conductor crimping portion crimping an outer conductor of the coaxial cable at a base end portion thereof.

According to the aspect (1), the molded portion covers the periphery of the convex portion provided on a surface of the base end portion and/or a surface of the tip end portion of the crimping terminal, and/or enters the recessed portion. Therefore, when an external force is applied to the inner conductor terminal, a part of the external force is received by a portion adhered to a lateral surface of the convex portion and/or a lateral surface of the recessed portion in the molded portion. As a result, compared with the case where the convex portion and the recessed portion are not provided, an excessive stress is less likely to act on an electrical connection portion (typically solder) that connects and fixes the base end portion of the connection terminal and the tip end portion of the crimping terminal to the chip-type electronic element. Accordingly, it is easy to favorably maintain the reliability of the electrical connection.

According to the aspect (2), the inside of the through hole is filled with the molded portion. Therefore, when an external force (in particular, a tensile force or a compressive force along the axial direction) is applied to the inner conductor terminal, a part of the external force can be received by a portion adhered to an inner wall surface of a through hole in the molded portion. As a result, an excessive stress is less likely to act on the electrical connection portion. Accordingly, it is easy to favorably maintain the reliability of the electrical connection.

Further, when the soldering is performed by a reflow method that is an electrical connection method, a part of molten solder drops, due to the action of gravity, through the through hole, even when an excessive amount of solder paste is placed on the mounting surfaces for the chip-type electronic element on the base end portion of the connection terminal and the tip end portion of the crimping terminal. Therefore, it is easy to properly maintain the amount of solder used for electrical connection.

According to the aspect (3), it is easy to favorably maintain the reliability of the electrical connection not only when a tensile force or a compressive force along the axial direction is applied to the inner conductor terminal, but also when a bending moment, which is in a direction in which one of the connection terminal and the crimping terminal is rotated with respect to the other one of the connection terminal and the crimping terminal around the axis of one of the through holes, is applied to the inner conductor terminal. That is, when such a bending moment is applied to the inner conductor terminal, a part of the bending moment is received by the portion adhered to a lateral surface of the protruding portion in the molded portion. As a result, an excessive stress is less likely to act on the electrical connection portion, compared with the case where the protruding portion is not provided on the inner wall surface of the through hole. Accordingly, it is easy to favorably maintain the reliability of the electrical connection.

According to the aspect (4), the molded portion covers the periphery of the convex portion, which is provided on a surface of the base end portion of the connection terminal and/or a surface of the tip end portion of the crimping terminal, and/or enters the recessed portion. Therefore, when an external force is applied to the inner conductor terminal, a part of the external force acts on a portion adhered to a lateral surface of the convex portion and/or a lateral surface of the recessed portion in the molded portion. As a result, compared with the case where the convex portion and the recessed portion are not provided, an excessive stress is less likely to act on an electrical connection portion (typically solder) that connects and fixes the base end portion of the connection terminal and the tip end portion of the crimping terminal to the chip-type electronic element. Accordingly, it is easy to favorably maintain the reliability of the electrical connection.

According to one or more embodiments, it is possible to provide an inner conductor terminal, which can maintain good electrical connection reliability and is provided with a chip-type electronic element, and a coaxial cable terminal unit using the inner conductor terminal.

The present invention has been briefly described as above. Details of the present invention is clarified by reading a mode for carrying out the present invention described below with reference to the accompanying drawings.

### BRIEF DESCRIPTION OF THE DRAWINGS

FIG. 1 is an exploded perspective view of a coaxial cable terminal unit according to the present embodiment.
FIG. 2 is a perspective view of the terminal unit in which assembly of three components illustrated in FIG. 1 is completed.
FIG. 3 is a perspective view illustrating a state in which an end portion of a coaxial cable is connected to the terminal unit illustrated in FIG. 2.
FIG. 4 is a perspective view of an inner conductor terminal.
FIG. 5 is a perspective view illustrating a terminal forming body that integrally includes a connection terminal, a crimping terminal, and a pair of bridge portions connecting the connection terminal with the crimping terminal.
FIG. 6 is a perspective view illustrating a stage in a manufacturing process of the inner conductor terminal in which a chip-type electronic element is mounted on the basis of the state illustrated in FIG. 5.
FIG. 7 is a perspective view illustrating a stage in the manufacturing process of the inner conductor terminal in which a molded portion is mounted on the basis of the state illustrated in FIG. 6.
FIG. 8A is a plan view schematically illustrating the periphery of an electrical connection portion between the chip-type electronic element and the base end portion of the connection terminal and of an electrical connection portion between the chip-type electronic element and the tip end portion of the crimping terminal according to the present embodiment. FIG. 8B is a cross-sectional view taken along a line A-A in FIG. 8A.
FIGS. 9A and 9B are views according to a comparative example, which correspond to FIGS. 8A and 8B. FIGS. 9A and 9B show a state of force transmission in a case where a compressive force along an axial direction is applied to an inner conductor terminal in the comparative example.
FIGS. 10A and 10B are views according to the present embodiment, which correspond to FIGS. 8A and 8B. FIGS. 10A and 10B show a state of force transmission in a case where a compressive force along an axial direction is applied to an inner conductor terminal in the present embodiment.
FIGS. 11A and 11B are views according to the modification of the present embodiment, which correspond to FIGS. 8A and 8B.
FIGS. 12A and 12B are views according to another modification of the present embodiment, which correspond to FIGS. 8A and 8B.
FIGS. 13A and 13B are views according to another modification of the present embodiment, which correspond to FIGS. 8A and 8B.

### DETAILED DESCRIPTION

### <Embodiment>

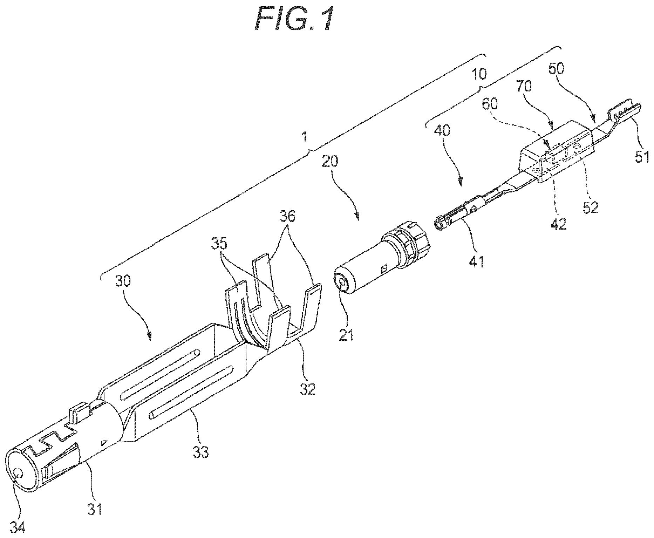

An inner conductor terminal 10 according to the embodiment of the present invention and a coaxial cable terminal unit 1 using the inner conductor terminal 10 will be described with reference to the drawings. For convenience of description, in an axial direction of the terminal unit 1, a side (left side in FIG. 1) to which a mating terminal (not illustrated) is fitted is referred to as a tip side (front side), and an opposite side thereof (right side in FIG. 1) is referred to as a base end side (rear side).

### <Configuration of Terminal Unit>

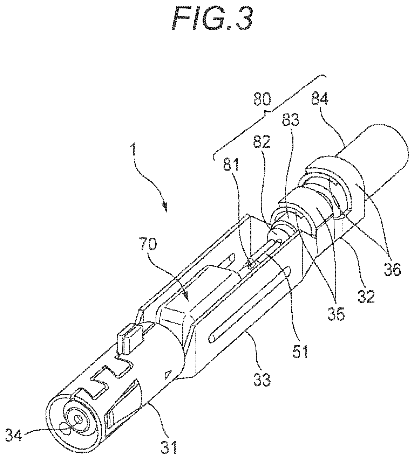

As illustrated in FIGS. 1 to 3, the coaxial cable terminal unit 1 includes an inner conductor terminal 10, a dielectric 20, and an outer conductor terminal 30. The terminal unit 1 is connected to an end portion of a coaxial cable 80 illustrated in FIG. 3, for example. The coaxial cable 80 includes a linear inner conductor 81, a cylindrical insulator 82 that covers the outer periphery of the inner conductor 81, a cylindrical outer conductor (braided conductor) 83 that covers the outer periphery of the insulator 82, and a cylindrical outer sheath 84 that covers the outer periphery of the outer conductor 83.

An antenna wire for an in-vehicle radio is typically assumed as the coaxial cable 80 that is connected to the terminal unit 1. Therefore, a chip-type electronic element 60 for adjusting electrostatic capacity and improving noise resistance is mounted on the inner conductor terminal 10 used for the terminal unit 1. Hereinafter, components constituting the terminal unit 1 will be described in order.

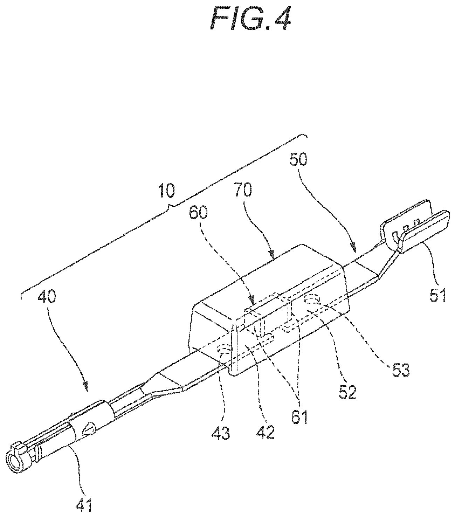

First, the inner conductor terminal 10 is described. The inner conductor terminal 10 has a function of being connected to the mating terminal (not illustrated), and being conductively connected to the inner conductor 81 of the coaxial cable 80. As illustrated in FIGS. 1 and 4, the inner conductor terminal 10 includes a connection terminal 40, a crimping terminal 50, a chip-type electronic element 60, and a molded portion 70.

The connection terminal 40 formed of metal includes, at a tip end portion thereof, a cylindrical connection portion 41 that is connected to the mating terminal. The mating terminal (male terminal) is inserted into a hollow portion (through hole) of the connection portion 41. A base end portion 42 of the connection terminal 40 has a flat-plate shape (strip shape) extending in the axial direction. A through hole 43 (in particular, see FIG. 4) that penetrates in a plate thickness direction is formed in the base end portion 42. The vicinity of the base end of the base end portion 42 (a region from the through hole 43 to the base end) is used as a mounting surface for the chip-type electronic element 60.

The crimping terminal 50 formed of metal includes, at a base end portion thereof, an inner conductor crimping portion 51 that is formed by a pair of crimping pieces for crimping the inner conductor 81 of the coaxial cable 80. A tip end portion 52 of the crimping terminal 50 has a flat-plate shape (strip shape) extending in the axial direction. A through hole 53 (in particular, see FIG. 4) that penetrates in a plate thickness direction is formed in the tip end portion 52. The vicinity of the tip end of the tip end portion 52 (a region from the through hole 53 to the tip end) is used as a mounting surface for the chip-type electronic element 60.

The chip-type electronic element 60 is mounted on the mounting surfaces of the base end portion 42 and the tip end portion 52 so as to couple the base end portion 42 with the tip end portion 52. The base end portion 42 of the connection terminal 40 and the tip end portion 52 of the crimping terminal 50 are spaced apart from each other by a predetermined distance and disposed to face each other in the axial direction. More specifically, between the pair of electrode portions 61 provided on both sides of the chip-type electronic element 60, one electrode portion 61 is mounted on the mounting surface of the base end portion 42 by soldering, and the other electrode portion 61 is mounted on the mounting surface of the tip end portion 52 by soldering. In this way, the chip-type electronic element 60 electrically connects the base end portion 42 of the connection terminal 40 with the tip end portion 52 of the crimping terminal 50 in series. A chip capacitor is typically mounted as the chip-type electronic element 60. Alternatively, a chip resistor, a chip diode, a chip inductor, or the like may be mounted as the chip-type electronic element 60.

The molded portion 70 is a molded body formed of resin, which covers the peripheries of the base end portion 42 of the connection terminal 40, the tip end portion 52 of the crimping terminal 50, and the chip-type electronic element 60 so as to be adhered to the entire outer periphery thereof. The molded portion 70 mainly has a function of protecting the chip-type electronic element 60. The configuration of the inner conductor terminal 10 has been described above. The manufacturing method of the inner conductor terminal 10 will be described below.

Next, the dielectric 20 will be described. The dielectric 20 has a function of accommodating and retaining the connection terminal 40 of the inner conductor terminal 10 and being accommodated and retained in the outer conductor terminal 30 to maintain the inner conductor terminal 10 and the outer conductor terminal 30 in an insulated state. As illustrated in FIG. 1, the dielectric 20 is formed of an insulating synthetic resin having a predetermined dielectric constant, and has a substantially cylindrical shape. A hollow portion (through hole) of the dielectric 20 functions as a terminal accommodation chamber 21 that accommodates and retains the connection terminal 40 of the inner conductor terminal 10.

Next, the outer conductor terminal 30 is described. The outer conductor terminal 30 has a function of accommodating and retaining the dielectric 20 and conductively being connected to the outer conductor 83 of the coaxial cable 80. As illustrated in FIG. 1, the outer conductor terminal 30 formed of metal integrally includes: a cylindrical shell portion 31, which is located at a tip end portion thereof and accommodates the dielectric 20; an outer conductor crimping portion 32, which is located at a base end portion thereof and crimps the outer conductor 83 of the coaxial cable 80; and an accommodation portion 33, which is located between the shell portion 31 and the outer conductor crimping portion 32, and accommodates and retains the molded portion 70 and the crimping terminal 50 of the inner conductor terminal 10.

The mating terminal (male terminal) is inserted into an opening 34 on a tip side of the shell portion 31. The outer conductor crimping portion 32 includes: a pair of crimping pieces 35, which are located at a tip side and crimp the outer conductor 83 of the coaxial cable 80; and a pair of crimping pieces 36, which are located at a base end side and crimp the outer sheath 84 of the coaxial cable 80. The accommodation portion 33 includes a bottom wall and a pair of side walls, and has a box shape whose top is opened.

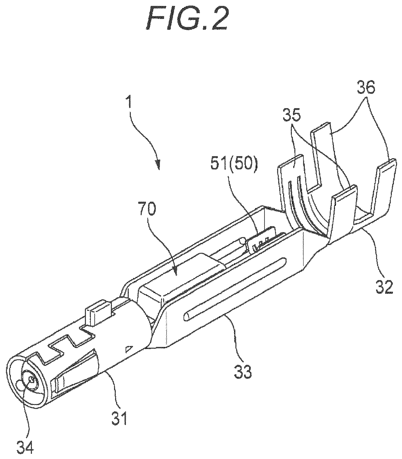

The components constituting the terminal unit 1 illustrated in FIG. 1 has been described above. During assembly of the terminal unit 1, first, the connection terminal 40 of the inner conductor terminal 10 is accommodated and retained in the terminal accommodation chamber 21 of the dielectric 20. Next, the dielectric 20, in which the connection terminal 40 is retained, is accommodated and retained in the shell portion 31 of the outer conductor terminal 30. As a result, as illustrated in FIG. 2, the molded portion 70 and the crimping terminal 50 of the inner conductor terminal 10 are accommodated and retained in the accommodation portion 33 of the outer conductor terminal 30. Accordingly, the assembly of the terminal unit 1 is completed.

As illustrated in FIG. 3, when the end portion of the coaxial cable 80 is connected to the terminal unit 1 which has been assembled, first, a predetermined terminal process is performed on the end portion of the coaxial cable 80 so that inner conductor 81 and the outer conductor 83 of the coaxial cable 80 are exposed to the outside. Next, the inner conductor 81 of the coaxial cable 80 is crimped and fixed by using a pair of crimping pieces of the inner conductor crimping portion 51 in the crimping terminal 50 of the inner conductor terminal 10. The outer conductor 83 and the outer sheath 84 of the coaxial cable 80 are crimped and fixed respectively by using the pair of crimping pieces 35 and the pair of crimping pieces 36 in the outer conductor crimping portion 32 of the outer conductor terminal 30. Accordingly, the connection between the end portion of the coaxial cable 80 and the terminal unit 1 is completed.

### <Manufacturing Method of Inner Conductor Terminal>

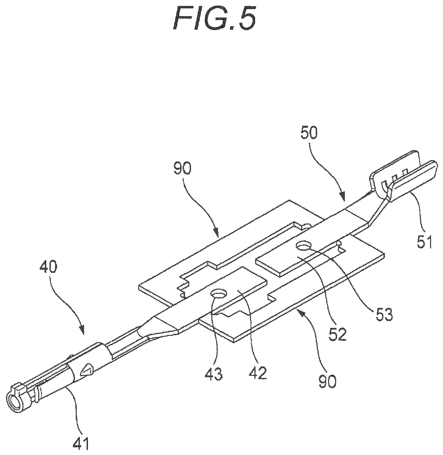

Next, the manufacturing method of the inner conductor terminal 10 illustrated in FIG. 4 will be described with reference to FIGS. 5 to 7. As illustrated in FIG. 5, first, a terminal forming body is formed, which includes the connection terminal 40, the crimping terminal 50, and a pair of bridge portions 90 that connects the connection terminal 40 with the crimping terminal 50. The base end portion 42 of the connection terminal 40 and the tip end portion 52 of the crimping terminal 50 are maintained, by a pair of bridge portions 90, in a state where the base end portion 42 and the tip end portion 52 are spaced apart from each other by a predetermined distance and disposed to face each other in the axial direction. The terminal forming body is formed by performing a predetermined punching process, a predetermined bending process, or the like on one flat conductive member formed of a metal material.

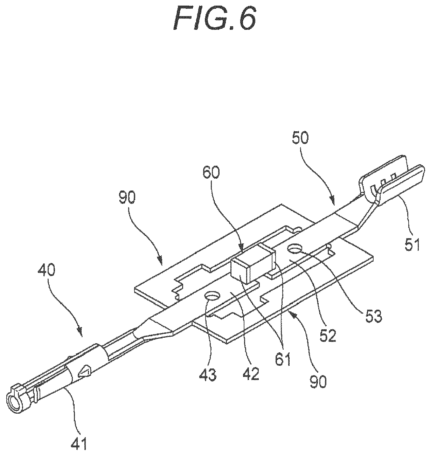

Next, as illustrated in FIG. 6, the chip-type electronic element 60 is mounted on mounting surfaces of the base end portion 42 and the tip end portion 52 so as to couple the base end portion 42 of the connection terminal 40 with the tip end portion 52 of the crimping terminal 50. Specifically, between the pair of electrode portions 61 of the chip-type electronic element 60, one electrode portion 61 is mounted on the mounting surface of the base end portion 42 by soldering, and the other electrode portion 61 is mounted on the mounting surface of the tip end portion 52 by soldering.

A reflow method is typically adopted as a method of soldering . When the reflow method is adopted, a part of molten solder drops, due to the action of gravity, through the through holes 43 and 53 respectively formed in the base end portion 42 and the tip end portion 52, even when an excessive amount of solder paste is placed on the mounting surfaces of the base end portion 42 of the connection terminal 40 and the tip end portion 52 of the crimping terminal 50. Therefore, it is easy to properly maintain the amount of solder used for electrical connection.

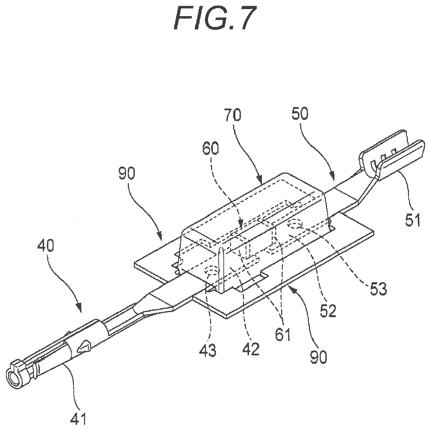

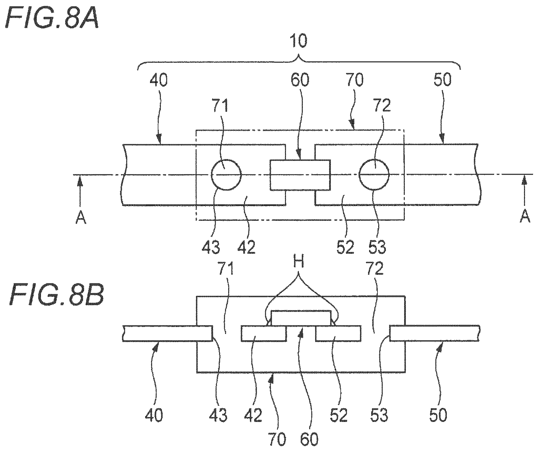

Next, as illustrated in FIG. 7, a molded portion 70 is formed by molding the peripheries of the base end portion 42 of the connection terminal 40, the tip end portion 52 of the crimping terminal 50, and the chip-type electronic element 60. The molded portion 70 is adhered to the entire outer peripheries of the base end portion 42, the tip end portion 52, and the chip-type electronic element 60. As illustrated in FIGS. 8A and 8B, the inside of the through hole 43 formed in the base end portion 42 and the inside of the through hole 53 formed in the tip end portion 52 are also integrally filled with the molded portion 70. The consequent actions and effects will be described below. Typically, a resin such as an epoxy resin, an ultraviolet curing resin, a hot melt resin is used for molding.

Next, the pair of bridge portions 90 connecting the connection terminal 40 with the crimping terminal 50 are cut and removed. Accordingly, the inner conductor terminal 10 illustrated in FIG. 4 is completed.

### <Actions and Effects caused by Filling Inside of Through Holes 43 and 53 with Molded Body 70>

As illustrated in FIGS. 8A and 8B above, in the inner conductor terminal 10 according to the present embodiment, the inside of the through hole 43 formed in the base end portion 42 of the connection terminal 40 and the inside of the through hole 53 formed in the tip end portion 52 of the crimping terminal 50 are also integrally filled with the molded portion 70. Hereinafter, the consequent actions and effects will be described.

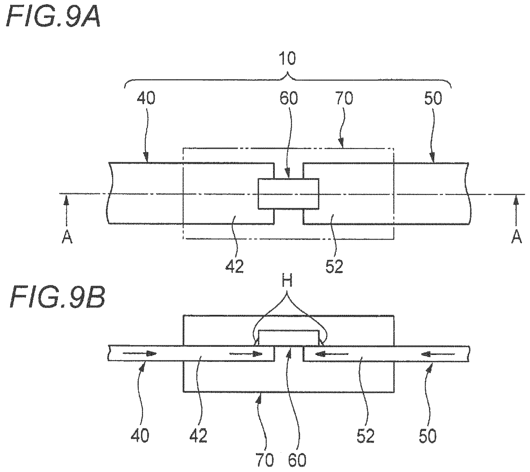

First, a mode is assumed as a comparative example to describe the actions and effects. In the mode, as illustrated in FIGS. 9A and 9B, no through hole is formed in either of the base end portion 42 of the connection terminal 40 and the tip end portion 52 of the crimping terminal 50 in the inner conductor terminal 10 according to the present embodiment.

In general, an adhesion force in adhesion portions is relatively small. The adhesion portions are respectively located between the molded portion 70 formed of resin and the base end portion 42 of the connection terminal 40 formed of metal, and between the molded portion 70 formed of resin and the tip end portion 52 of the crimping terminal 50 formed of metal. Therefore, in the comparative example, when a compressive force along the axial direction is applied to the inner conductor terminal 10 as indicated by an arrow in FIG. 9B, most of the compressive force (more accurately, a compressive force excluding the adhesion force) is applied to solder H that connects and fixes the base end portion 42 and the tip end portion 52 to the chip-type electronic element 60 (see FIG. 9B). Accordingly, an excessive stress is likely to act on the solder H. As a result, reliability of the electrical connection via the solder H is less likely to maintain favorably.

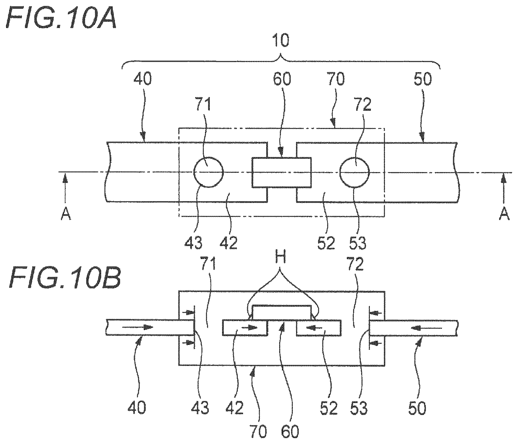

In contrast, as illustrated in FIGS. 10A and 10B, the insides of the through hole 43 and the through hole 53 are also filled with the molded portion 70 in the present embodiment. Therefore, as illustrated in FIG. 10B, when a compressive force along the axial direction is applied to the inner conductor terminal 10, a part of the compressive force is received by the portion 71 adhered to an inner wall surface of the through hole 43 and the portion 72 adhered to an inner wall surface of the through hole 53 in the molded portion 70. As a result, an excessive stress is less likely to act on the solder H only in view of the magnitude of forces received by the portions 71 and 72. Accordingly, it is easy to favorably maintain the reliability of the electrical connection via the solder H. The above-described actions and effects can be exerted not only when a compressive force along the axial direction is applied but also when a tensile force along the axial direction is applied.

As described above, according to the inner conductor terminal 10 and the terminal unit 1 of the embodiment of the present invention, the insides of the through holes 43 and 53 (recessed portions), which are respectively provided at the base end portion 42 of the connection terminal 40 and the tip end portion 52 of the crimping terminal 50, are integrally filled with the molded portion 70. Therefore, when an external force (in particular, a tensile force or a compressive force along the axial direction) is applied to the inner conductor terminal 10, a part of the external force is received by the portion 71 adhered to the inner wall surface of the through hole 43 and the portion 72 adhered to the inner wall surface of the through hole 53 in the molded portion 70 (see FIG. 10B). As a result, compared with the case where such through holes 43 and 53 are not provided, an excessive stress is less likely to act on the solder H (see FIG. 10B) that connects and fixes the base end portion 42 and the tip end portion 52 to the chip-type electronic element 60. Accordingly, it is easy to favorably maintain the reliability of the electrical connection.

Further, when the soldering is performed by the reflow method, a part of molten solder drops, due to the action of gravity, through the through holes 43 and 53, even when an excessive amount of solder paste is placed on the mounting surfaces of the base end portion 42 of the connection terminal 40 and the tip end portion 52 of the crimping terminal 50. Therefore, it is easy to properly maintain the amount of solder used for electrical connection.

### <Other Embodiments>

The present invention is not limited to the above-described embodiment, and various modifications can be adopted within the scope of the present invention. For example, the present invention is not limited to the above-described embodiment, but can be appropriately modified, improved, and the like. In addition, materials, shapes, dimensions, numerals, disposition locations or the like of constituent elements in the above-described embodiment are optional and not limited as long as the object of the present invention can be achieved.

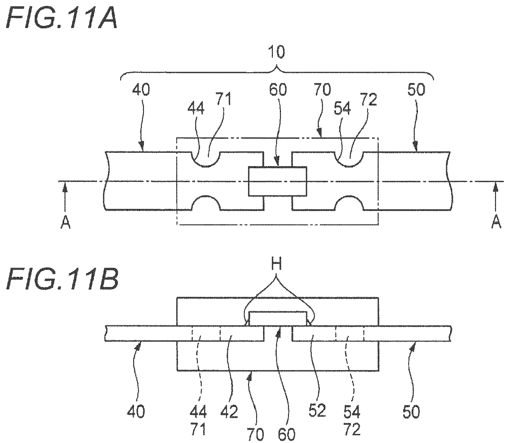

In the above embodiment, the through holes 43 and 53 (recessed portions) are formed in the base end portion 42 of the connection terminal 40 and the tip end portion 52 of the crimping terminal 50, respectively. The inside of the through hole 43 is integrally filled with the portion 71 of the molded portion 70, and the inside of the through hole 53 is integrally filled with the portion 72 of the molded portion 70 (see FIGS. 8A and 8B). In contrast, as illustrated in FIGS. 11A and 11B, notches 44 and notches 54 (recessed portions) are formed on both side surfaces of the base end portion 42 of the connection terminal 40 and the tip end portion 52 of the crimping terminal 50, respectively. The insides of the notches 44 are integrally filled with the portion 71 of the molded portion 70, and the insides of the notches 54 are integrally filled with the portion 72 of the molded portion 70.

In the present embodiment, when an external force (in particular, a tensile force or a compressive force along the axial direction) is applied to the inner conductor terminal 10, a part of the external force is also received by the portion 71 adhered to an inner wall surface of the notch 44 and the portion 72 adhered to an inner wall surface of the notch 54 in the molded portion 70. As a result, an excessive stress is less likely to act on the solder H (see FIG. 11B). Accordingly, it is easy to favorably maintain the reliability of the electrical connection.

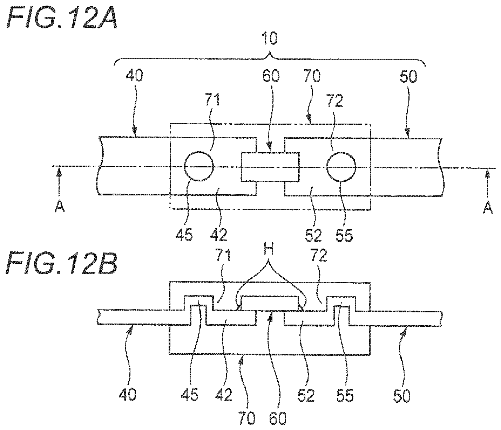

Further, as illustrated in FIGS. 12A and 12B, a convex portion 45 and a convex portion 55, instead of the through hole 43 and the through hole 53 (recessed portions), are formed on the base end portion 42 of the connection terminal 40 and the tip end portion 52 of the crimping terminal 50, respectively. The periphery of the convex portion 45 may be integrally covered with the portion 71 of the molded portion 70, and the periphery of the convex portion 55 may be integrally covered with the portion 72 of the molded portion 70. The convex portion 45 and the convex portion 55 can be formed by, for example, extruding the connection terminal 40 and the crimping terminal 50 from the lower side to the upper side in the drawing. In this case, as illustrated in FIGS. 12A and 12B, a depression is separately formed in positions corresponding to the convex portion 45 on a lower surface of the connection terminal 40 and the convex portion 55 on a lower surface of the crimping terminal 50.

In the present embodiment, when an external force (in particular, a tensile force or a compressive force along the axial direction) is applied to the inner conductor terminal 10, a part of the external force is also received by the portion 71 adhered to a lateral surface of the convex portion 45 and the portion 72 adhered to a lateral surface of the convex portion 55 in the molded portion 70. As a result, an excessive stress is less likely to act on the solder H (see FIG. 12B). Accordingly, it is easy to favorably maintain the reliability of the electrical connection.

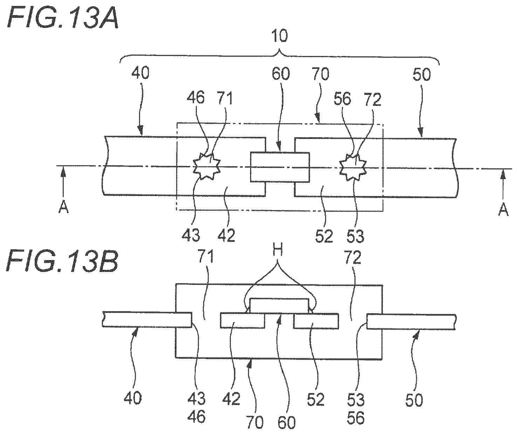

Further, as illustrated in FIGS. 13A and 13B, a plurality of protruding portions 46, which extend from the inner wall surface of the through hole 43 toward a radially inner side, are formed in the through hole 43 provided in the base end portion 42 of the connection terminal 40, and a plurality of protruding portions 56, which extend from the inner wall surface of the through hole 53 toward the radially inner side, are formed in the through hole 53 provided in the tip end portion 52 of the crimping terminal 50. The inside of the through hole 43 may be integrally filled with the portion 71 of the molded portion 70, and the inside of the through hole 53 may be integrally filled with the portion 72 of the molded portion 70.

In the present embodiment, it is easy to favorably maintain the reliability of the electrical connection not only when a tensile force or a compressive force along the axial direction is applied to the inner conductor terminal 10, but also when a bending moment, which is in a direction in which one of the connection terminal 40 and the crimping terminal 50 is rotated with respect to the other one of the connection terminal 40 and the crimping terminal 50 around the axis of one of the through holes 43 and 53, is applied to the inner conductor terminal 10. That is, when such a bending moment is applied to the inner conductor terminal 10, a part of the bending moment is received by the portion 71 adhered to a lateral surface of the protruding portion 46 and the portion 72 adhered to a lateral surface of the protruding portion 56 in the molded portion 70. As a result, an excessive stress is less likely to act on the solder (see FIG. 13B), compared with the case where protruding portions 46 and 56 are not provided on the inner wall surfaces of the through holes 43 and 53. Accordingly, it is easy to favorably maintain the reliability of the electrical connection.

Further, in the above-described embodiment and embodiments illustrated in FIGS. 11A to 13B, a recessed portion or a convex portion is formed on both the base end portion 42 of the connection terminal 40 and the tip end portion 52 of the crimping terminal 50. In contrast, a recessed portion or a convex portion may be formed on only one of the base end portion 42 of the connection terminal 40 and the tip end portion 52 of the crimping terminal 50.

The characteristics of the embodiments of the above inner conductor terminal 10 and the terminal unit 1 according to the present invention will be briefly summarized and listed in the following [1] to [4].
[1] An inner conductor terminal (10) comprising:
   a connection terminal (40);
   a crimping terminal (50);
   a chip-type electronic element (60); and
   a molded portion (70),
   wherein the connection terminal (40) includes a connection portion (41) that is connected to a mating terminal at a tip end portion thereof,
   wherein the crimping terminal (50) includes an inner conductor crimping portion (51) that crimps an inner conductor (81) of a coaxial cable (80) at a base end portion thereof,
   wherein the chip-type electronic element (60) is mounted on a base end portion (42) of the connection terminal (40) and a tip end portion (52) of the crimping terminal (50) so as to couple the base end portion (42) of the connection terminal (40) with the tip end portion (52) of the crimping terminal (50),
   wherein the molded portion (70) covers peripheries of the base end portion (42) of the connection terminal (40), the tip end portion (52) of the crimping terminal (50), and the chip-type electronic element (60),
   wherein at least one of the base end portion (42) of the connection terminal (40) and the tip end portion (52) of the crimping terminal (50) includes a convex portion (45, 55) or a recessed portion (43, 44, 53, 54) on a surface thereof, and
   wherein the molded portion (70) covers a periphery of the convex portion (45, 55) or enters the recessed portion (43, 44, 53, 54).
[2] The inner conductor terminal (10) according to the above-described [1],
   wherein each of the base end portion (42) of the connection terminal (40) and the tip end portion (52) of the crimping terminal (50) has a flat-plate shape,
   wherein the recessed portion includes a through hole (43, 53) penetrating in a plate thickness direction, and
   wherein the inside of the through hole (43, 53) is filled with the molded portion (70).
[3] The inner conductor terminal (10) according to the above-described [2],
   wherein the through hole (43, 53) includes a protruding portion (46, 56) extending from an inner wall surface of the through hole (43, 53) toward a radially inner side.
[4] A coaxial cable terminal unit (1) comprising:
   the inner conductor terminal (10) according to any one of the above-described [1] to [3];
   a dielectric (20); and
   an outer conductor terminal (30),
   wherein a terminal accommodation chamber (21) accommodating and retaining the inner conductor terminal (10) is formed through the dielectric (20), and
   wherein the outer conductor terminal (30) includes a shell portion (31) internally provided with the dielectric (20) at a tip end portion thereof and an outer conductor crimping portion (32) crimping an outer conductor (83) of the coaxial cable (80) at a base end portion thereof.

### [Description of Reference Numerals and Signs]

1: terminal unit
10: inner conductor terminal
20: dielectric
21: terminal accommodation chamber
30: outer conductor terminal
31: shell portion
32: outer conductor crimping portion
40: connection terminal
41: connection portion
42: base end portion
43: through hole (recessed portion)
44: notch (recessed portion)
45: convex portion
46: protruding portion
50: crimping terminal
51: inner conductor crimping portion
52: tip end portion
53: through hole (recessed portion)
54: notch (recessed portion)
55: convex portion
56: protruding portion
60: chip-type electronic element
70: molded body (molded portion)
80: coaxial cable
81: inner conductor
83: outer conductor

## Claims

1. An inner conductor terminal comprising:
a connection terminal;
a crimping terminal;
a chip-type electronic element; and
a molded portion,
wherein the connection terminal includes a connection portion that is connected to a mating terminal at a tip end portion thereof,
wherein the crimping terminal includes an inner conductor crimping portion that crimps an inner conductor of a coaxial cable at a base end portion thereof,
wherein the chip-type electronic element is mounted on a base end portion of the connection terminal and a tip end portion of the crimping terminal so as to couple the base end portion of the connection terminal with the tip end portion of the crimping terminal,
wherein the molded portion covers peripheries of the base end portion of the connection terminal, the tip end portion of the crimping terminal, and the chip-type electronic element,
wherein at least one of the base end portion of the connection terminal and the tip end portion of the crimping terminal includes a convex portion or a recessed portion on a surface thereof, and
wherein the molded portion covers a periphery of the convex portion or enters the recessed portion.

2. The inner conductor terminal according to claim 1,
wherein each of the base end portion of the connection terminal and the tip end portion of the crimping terminal has a flat-plate shape,
wherein the recessed portion includes a through hole penetrating in a plate thickness direction, and
wherein the inside of the through hole is filled with the molded portion.

3. The inner conductor terminal according to claim 2,
wherein the through hole includes a protruding portion extending from an inner wall surface of the through hole toward a radially inner side.

4. A coaxial cable terminal unit comprising:
the inner conductor terminal according to any one of claims 1 to 3;
a dielectric; and
an outer conductor terminal,
wherein a terminal accommodation chamber accommodating and retaining the inner conductor terminal is formed through the dielectric, and
wherein the outer conductor terminal includes a shell portion internally provided with the dielectric at a tip end portion thereof and an outer conductor crimping portion crimping an outer conductor of the coaxial cable at a base end portion thereof.
